# EUROPÄISCHE PATENTSCHRIFT

(11) **EP 1 565 591 B1**
(45) Veröffentlichungstag und Bekanntmachung des Hinweises auf die Patenterteilung: **10.10.2007**
(21) Anmeldenummer: 03757995.0
(22) Anmeldetag: 16.10.2003
(51) Int. Cl.: C23C 14/02

(54) **VERFAHREN ZUM BEDAMPFEN BANDFO RMIGER SUBSTRATE MIT EINER TRA NSPARENTEN BARRIERESCHICHT AUS ALUMINIUMOXID**
METHOD FOR VAPOR-DEPOSITING STRIP-SHAPED SUBSTRATES WITH A TRANSPARENT BARRIER LAYER MADE OF ALUMINUM OXIDE
PROCEDE DE METALLISATION DE SUBSTRATS EN FORME DE BANDE PAR DEPOT SOUS VIDE D'UNE COUCHE BARRIERE TRANSPARENTE D'OXYDE D'ALUMINIUM

(30) Priorität: 29.11.2002 DE 10255822
(43) Veröffentlichungstag der Anmeldung: 24.08.2005
(73) Patentinhaber: Fraunhofer-Gesellschaft zur Förderung der angewandten Forschung e.V., 80686 München (DE)
(72) Erfinder: SCHILLER, Nicolas, 01833 Stolpen, OT Helmsdorf (DE); STRAACH, Steffen, 01187 Dresden (DE); RAEBISCH, Mathias, 01848 Hohnstein OT Hohburkersdorf (DE); FAHLAND, Matthias, 01259 Dresden (DE); CHARTON, Christoph, 93437 Furth i. Wald (DE)
(86) Internationale Anmeldenummer: PCT/EP2003/011477
(87) Internationale Veröffentlichungsnummer: WO 2004/050945

(56) Entgegenhaltungen:
- DE-C- 4 343 040
- US-A- 5 792 550
- SCHILLER N ET AL: "Application of the magnetron activated deposition process (MAD-process) to coat polymer films with alumina in web coaters" 23RD INTERNATIONAL CONFERENCE ON METALLURGICAL COATINGS AND THIN FILMS, SAN DIEGO, CA, USA, 22-26 APRIL 1996, Bd. 86-87, Nr. 1-3, pt.2, Seiten 776-782, XP002280664 Surface and Coatings Technology, 15 Dec. 1996, Elsevier, Switzerland ISSN: 0257-8972 in der Anmeldung erwähnt

## Beschreibung

Die Erfindung betrifft ein Verfahren zum Aufdampfen einer Barriereschicht aus Aluminiumoxid auf bandförmige Substrate im Vakuum.
Die Beschichtung vorzugsweise bandförmiger Substrate mit einer Barriereschicht ist ein wichtiger Prozessschritt bei der Herstellung von verschiedenen Verpackungsmaterialien. Insbesondere Polymermaterialien werden nach Aufdampfen einer dünnen Metallschicht (z. B. Aluminium) zu Verpackungsmaterialien weiterverarbeitet, die eine hohe Sperrwirkung gegenüber Sauerstoff und Wasserdampf, evtl. auch gegenüber Aromastoffen, aufweisen. Verpackungen, die eine dünne Metallschicht enthalten, sind undurchsichtig und haben eine hohe Mikrowellenabsorption. Das ist für manche Anwendungen im Bereich der Lebensmittelverpackungen von Nachteil. Deshalb werden zunehmend metallische Barriereschichten durch verschiedene Barriereschichten auf Oxidbasis (Oxide von Si, Al, Mg) ersetzt.

Die reaktive Verdampfung von Aluminium aus dem Schiffchenverdampfer stellt dabei eine Möglichkeit dar, den Vorteil einer niedrigen Verdampfungstemperatur mit einer hohen optischen Transparenz und guter Mikrowellendurchlässigkeit des Endproduktes zu kombinieren. Daneben kommen jedoch auch Verfahren mit Elektronenstrahl- bzw. Induktionsverdampfern in Frage.
Für Barrierebeschichtungen dieser Art gilt, dass die optische Transmission vom Mischungsverhältnis zwischen Aluminium und seinem Oxid - im Folgenden auch als Stöchiometrie bezeichnet - abhängt. Mit steigendem Oxidanteil nimmt die optische Transmission zu, während sich damit jedoch die Barrierewirkung der Schicht verringert. Es existiert ein Arbeitsbereich im leicht unterstöchiometrischen Bereich, dessen untere Grenze durch die höchstzulässige Absorption und dessen obere Grenze durch die geforderten Mindestwerte der Barriere bestimmt wird [Schiller, N.; Reschke, J.; Goedicke, K.; Neumann, M.: Surface and Coatings Technology, 86-87 (1996) 776-782].
Es ist deshalb üblich, die Einhaltung dieses Arbeitsbereiches durch Bereitstellung der Reaktionspartner Aluminium und Sauerstoff in einem bestimmten einstellbaren Mengenverhältnis zu gewährleisten (JP 62-103 359 A).
Da gerade auf dem Gebiet von Massenverpackungen die visuelle Beurteilung des fertigen Produkts eine große Rolle spielt und geringe Schwankungen der Transmission sehr schnell wahrgenommen werden können, wurden bereits zahlreiche Versuche unternommen, eine gleichmäßige Transmission über große Beschichtungsflächen zu erzielen, wobei neben der Transmission stets auch eine ausreichende Schichthaftung angestrebt werden musste, um eine Barrierewirkung zu erzielen.

Es ist bekannt, dass durch die Messung der optischen Transmission der reaktiv aufgedampften Schichten die Steuerung des Prozesses möglich ist, indem bei vorgegebenem Gasstrom die Verdampfungsrate so nachgeführt wird, dass ein vorgegebener Transmissionswert eingehalten wird. Das ist bei der reaktiven Elektronenstrahlverdampfung realisiert (DE 44 27 581 A1). Mit einem Schiffchenverdampfer ist diese Form der Regelung nicht durchführbar, da die Verdampferschiffchen für schnelle Änderungen des Heizstromes - und damit der Verdampfungsrate - ungeeignet und für eine derartige Regelung zu träge sind.

Es ist weiterhin bekannt, dass durch die Einstellung eines bestimmten Reaktivgasflusses, der bei konstanter Verdampfungsrate zu schwach absorbierenden Schichten führt, das Mischungsverhältnis zwischen dem verdampften Metall und seinem Oxid im Wesentlichen gleichförmig gehalten werden kann (EP 0 437 946 B1). Es besteht aber der Nachteil, dass das Verfahren technologisch aufwendig ist, da hohe Anforderungen an die Konstanthaltung der Verdampfungsrate, insbesondere bei Einsatz mehrerer Verdampferschiffchen, gestellt werden müssen.

Es ist weiterhin bekannt, Aluminiumoxidschichten deutlich unterstöchiometrisch aufzudampfen. Die erzielte optische Transmission liegt zunächst unterhalb des oben erwähnten Arbeitsbereiches. In einem Nachoxidationsschritt, der plasmaaktiviert direkt nach der Bedampfung oder ohne Aktivierung bei einem zusätzlichen Umwickeln erfolgt, wird die Schicht nachträglich aufgehellt (EP 0 555 518 B1, EP 0 695 815 B1). Dieser zusätzliche Prozessschritt bedeutet jedoch einen technologischen Mehraufwand.

Weiterhin ist bekannt, dass bei der Aufdampfung sehr dünner unterstöchiometrischer Oxidschichten und anschließender relativ langer Verweildauer in der Reaktivgasatmosphäre die Nachoxidation - eventuell plasmaaktiviert - spontan zur ausreichenden Aufhellung der Schicht führt. Durch die Nutzung eines Bandlaufwerkes, welches über zusätzliche Umlenkrollen den Weg des bedampften Substrates im Rezipienten wesentlich verlängert und es daneben gestattet, den Bedampfungszyklus mehrfach zu durchlaufen, können hinreichend transparente Schichten üblicher Dicke aufgedampft werden, indem mehrere sehr dünne und einzeln nachoxidierte Schichten übereinander aufgedampft werden (US 5,462,602).

Das Verfahren erfordert jedoch einen erheblichen mechanischen Mehraufwand am Bandlaufwerk.

Es ist bekannt, dass Barriereschichten, welche als Einzelschichten die Mindestanforderungen bezüglich ihrer Barrierewirkung nicht erfüllen, in Mehrschichtsystemen ausreichende Barrierewirkungen zeigen. Die Kombination von aufgestäubten und aufgedampften Schichten ist eine solche Lösung, die auch für Aluminiumoxid vorgeschlagen wurde (DE 43 43 040 C1). Die Beschichtung erfolgt in diesem Fall mit stark unterschiedlicher Beschichtungsrate. Die Realisierung mehrerer aufeinanderfolgender Prozessschritte, die unterschiedliche Durchlaufzeiten bedingen, stellt jedoch ebenfalls einen erheblichen technischen Mehraufwand dar. Außerdem wird die Barrierewirkung derartiger Schichten oft dadurch beschränkt, dass sich in den einzelnen Schichten unterschiedliche Schichtspannungen aufbauen, weshalb es, ausgehend von den Übergangsbereichen, allmählich zu Rissbildungen kommen kann.

Weiterhin ist bekannt, dass durch eine Prozessführung, die es verhindert, dass die Dichte der Barriereschicht unter einen bestimmten Grenzwert sinkt, gute Barriereeigenschaften erzielt werden können. So wird für Aluminiumoxid 2,7 g/cm³ als unterer Grenzwert der Dichte beansprucht (EP 0 812 779 A2). Da die Dichte einer Aufdampfschicht jedoch stark von den Kondensationsbedingungen abhängt, stellt ein vorgegebener Mindestwert stets eine deutliche Einschränkung bei der Prozessführung dar. Insbesondere bei der Umrüstung bestehender Aluminiumbedampfungsanlagen für den Prozess der reaktiven Aufdampfung von Aluminiumoxidschichten sind durch konstruktive Gegebenheiten oftmals Kondensationsbedingungen vorgegeben, die nur mit sehr großem Aufwand zu verändern sind und die Umrüstung insgesamt unwirtschaftlich werden lassen. Außerdem ist die Dichte der Schicht kein Parameter, der während des Prozesses direkten Messungen zugänglich ist.

Weiterhin ist bekannt, vor der Beschichtung mit der eigentlichen Barriereschicht das Substrat mit einer dünnen Nukleationsschicht mit einer ungefähren Dicke von 5 nm zu versehen (US 5,792,550). Auch das bedeutet in vielen Fällen einen zusätzlichen Prozessschritt, der die Produktionskosten deutlich erhöht.

Es ist außerdem bekannt, das Substrat mit einem Magnetronplasma zu behandeln, bevor die Beschichtung mit der Barriereschicht erfolgt [Löbig, G. et al.; SVC 41 st Annual Technical Conference Proceedings (1998) S.502]. Das bewirkt eine Aktivierung und Reinigung der Substratoberfläche und sorgt für eine verbesserte Schichthaftung. Dadurch ist die Barrierewirkung etwas weniger abhängig von der Stöchiometrie der Barriereschicht. Für viele Anwendungen reicht die auf diese Weise erzielbare Barrierewirkung jedoch ebenfalls nicht aus.

Schließlich ist bekannt, die Barriereschicht mit einem Stöchiometriegradienten aufzudampfen (DE 198 45 268 C1). In derartigen Schichten stellt jedoch die genaue Einstellung der Stöchiometrie im Grenzbereich zwischen Schicht und Substrat einen sehr sensiblen Parameter dar.

Aufgabe der Erfindung ist es, ein Verfahren zu schaffen, mit welchem auf bandförmigen Substraten transparente Barriereschichtsysteme, umfassend eine durch reaktive Verdampfung abgeschiedene Aluminiumoxidbarriereschicht, hergestellt werden können. Mittels des Verfahrens soll das technische Problem der Rissbildung im Schichtsystem überwunden werden. Die abgeschiedenen Barriereschichten sollen über gute Barriereeigenschaften und als Vorraussetzung dessen über eine hohe Haftfestigkeit verfügen. Des Weiteren soll das Verfahren auch durch das Nachrüsten bestehender Aluminiumbedampfungsanlagen ausführbar sein.

Erfindungsgemäß wird die Aufgabe nach Patentanspruch 1 gelöst. Vorteilhafte Ausgestaltungen des Verfahrens ergeben sich aus den abhängigen Patentansprüchen.

Die Erfindung beruht auf der Erkenntnis, dass die Barrierewirkung einer Aluminiumoxidschicht wesentlich weniger stöchiometrieabhängig ist, wenn das Substrat vor der Bedampfung mit der Aluminiumoxidschicht mit einer extrem dünnen aufgestäubten Metall- oder Metalloxidschicht versehen wird. Unter extrem dünn wird dabei eine Schichtdicke verstanden, bei der sich noch keine geschlossene Schicht bilden kann. Das ist auf jeden Fall auszuschließen, wenn die Flächenbelegung nicht für Ausbildung einer vollständigen Atom- oder Moleküllage reicht, aber auch etwas höhere Flächenbelegungen führen noch nicht zur Ausbildung geschlossener Schichten. Der Aufstäubungsprozess, auch Sputtern genannt, bedingt eine Reinigung und Aktivierung der Substratoberfläche. Das erhöht die Schichthaftung. Die gleichzeitig aufgesputterten Metallatome oder Metalloxidmoleküle weisen außerdem durch die für Sputterprozesse typische Auftreffenergie eine besonders gute Haftung auf, wie sie auch von dickeren gesputterten Schichten bekannt ist. Vorteilhaft ist jedoch, dass sich durch die unvollständige Bedeckung des Substrates mit einer nicht geschlossenen Schicht keinerlei Schichtspannungen aufbauen.

Die nach dem Sputtern noch nicht bedeckten Substratbereiche stehen außerdem aktiviert und gereinigt für die Beschichtung mit der eigentlichen Barriereschicht aus Aluminiumoxid zur Verfügung. Es wurde festgestellt, dass bei einer derartigen Vorbeschichtung die Abhängigkeit der Barrierewirkung von der Schichtstöchiometrie wesentlich schwächer ausgeprägt ist, als ohne diese Vorbeschichtung.
Besonders gute Barrierewirkungen lassen sich erreichen, wenn anschließend eine plasmaaktivierte reaktive Bedampfung des vorbeschichteten Substrates mit Aluminiumoxid erfolgt. Zur Plasmaaktivierung eignet sich besonders ein dichtes Hohlkathodenbogenentladungsplasma. Dessen Wirkung kann durch eine magnetische Verstärkung zusätzlich gesteigert werden. Dies bedingt eine besonders geringe Abhängigkeit der Barrierewirkung von der Schichtstöchiometrie bei konstant guten Barrierewerten. Offenbar bewirkt dieses spezielle Plasma durch seine hohe Ladungsträgerdichte die Ausbildung einer für Barriereschichten optimalen Schichtstruktur. Als vorteilhaft hat sich ein Plasma erwiesen, das am Substrat eine durchschnittliche extrahierbare Ionenstromdichte von mindestens 20 mA/cm² bereitstellt. Besonders vorteilhaft sind Ionenstromdichten von über 50 mA/cm².
Eine besonders vorteilhafte Ausführung des erfindungsgemäßen Verfahrens ergibt sich bei Ausnutzung der Tatsache, dass die Barriere gegenüber Sauerstoff nicht in gleicher Weise von der Stöchiometrie abhängt, wie die Barriere gegenüber Wasserdampf. Versuche haben ergeben, dass der Grad, in dem bestimmte Tiefenbereiche der Schicht zur Barrierewirkung der Gesamtschicht beitragen, in unterschiedlichem Maße von der Stöchiometrie abhängt. Wird die optische Transmission der gesamten Schicht entsprechend den späteren anwendungsbedingten Anforderungen konstant gehalten, so kann die Absorption der unterschiedlichen Tiefenbereiche der Schicht durchaus variieren. Eine Schicht mit über die gesamte Schichtdicke gleichmäßig verteilter Stöchiometrie ist nicht von einer Stapelstruktur aus vollständig transparenten und stärker unterstöchiometrischen Teilschichten zu unterscheiden. Gleiches gilt für Schichten, die bezüglich der Stöchiometrie als Gradientenschichten ausgebildet sind. Unterschiedliche Gradienten sind aus der Vermessung der optischen Transmission nicht zu ersehen, solange sich die Absorption der Gesamtschicht nicht ändert.
Liegt nun ein überstöchiometrischer Bereich in der Nähe des Substrates, ergeben sich schlechte Barrierewerte gegenüber Wasserdampf und mäßige Werte gegenüber Sauerstoff. Enthält der untere Teil der Schicht dagegen einen unterstöchiometrischen Bereich, lassen sich gute Wasserdampf- und Sauerstoffbarrierewerte erzielen.

Es sind also erfindungsgemäß unterstöchiometrische Bereiche im substratnahen unteren Teil der Schicht anzustreben. Die anderen Bereiche der Schicht können durchaus überstöchiometrisch sein. Diese Bereiche tragen immerhin noch zur Sauerstoffbarriere bei, haben jedoch auf die Wasserdampfbarriere kaum einen Einfluss. Es lässt sich ableiten, dass diese Bereiche auch von geringerer Dichte sein werden, weshalb der Dichte der Gesamtschicht kaum eine Bedeutung zukommt.
Durch reaktive Aluminiumverdampfung in Kombination mit der Aktivierung durch ein Hohlkathodenbogenentladungsplasma und einem erfindungsgemäßen Vorsputtern, beispielsweise mit Titan oder Magnesium oder reaktiv mit deren Oxid, lassen sich Barriereschichten mit exzellenter Barrierewirkung erzeugen. Besonders vorteilhaft ist dabei, dass sich beide Beschichtungsschritte mit der gleichen Durchlaufzeit des Substrates realisieren lassen, da sich die Beschichtungsraten in einem ähnlichen Verhältnis zueinander bewegen wie die Flächenbelegungen durch die nicht geschlossene Sputterschicht und die eigentliche Barriereschicht. Somit kann die Beschichtung in einem einzigen Durchlauf erfolgen.

Das erfindungsgemäße Verfahren besteht in der Vorbeschichtung des Substrates durch reaktives oder nichtreaktives Sputtern mit einer nicht geschlossenen Schicht aus einem Metall oder dessen Oxid und einer anschließenden reaktiven Verdampfung von Aluminium aus einem Schiffchenverdampfer, einem Induktionsverdampfer oder einem Elektronenstrahlverdampfer. Vorteilhafterweise wird der Schritt der reaktiven Bedampfung durch eine Plasmaaktivierung ergänzt und das Reaktivgas in einer Weise eingelassen, dass sich entlang der Bedampfungszone in Bandlaufrichtung ein geeigneter Partialdruckgradient des Reaktivgases einstellt.
Mit dem erfindungsgemäßen Verfahren lassen sich so Aluminiumoxidschichten auf bandförmige Substrate aufdampfen, die bezüglich ihrer Stöchiometrie bzw. des Mischungsverhältnisses zwischen dem verdampften Metall und seinem Oxid als Gradientenschichten oder als Stapelschichten ausgebildet sind und deren unterstöchiometrischster Bereich im substratnahen Teil der Schicht liegt. Gradientenschichten haben in diesem Falle gegenüber Stapelstrukturen den Vorteil, dass sie sich in einem Verfahrensschritt aufdampfen lassen.

Der im sichtbaren Bereich absorbierende Tiefenbereich der Schicht kann sehr dünn, d. h. bei <10 nm gehalten werden. Da an so dünnen Schichten Schwankungen im Grad der Unterstöchiometrie erst bei deutlichen Abweichungen sichtbar werden, und Veränderungen in überstöchiometrischen Bereichen - solange sie nur überstöchiometrisch oder zumindest stöchiometrisch bleiben - keinen Einfluss auf die Absorption der Gesamtschicht haben, sind die Anforderungen an die Einhaltung einer gerade noch tolerablen Absorption wesentlich unkritischer, als das bei Schichten mit im Wesentlichen gleichmäßiger Stöchiometrie der Fall ist.

Die reaktive Verdampfung kann auch für den Fall der Ausbildung von Gradientenschichten plasmaaktiviert erfolgen, was die Barriereeigenschaften des Endproduktes weiter verbessert. Der wesentliche Vorteil des Verfahrens unter Einbeziehung von Gradientenschichten besteht in der extrem geringen Dicke der unterstöchiometrischen Schicht, wodurch erst bei sehr niedrigem Oxidationsgrad ein nennenswerter Transmissionsverlust eintritt. Dadurch wird in den meisten Fällen ein zusätzlicher Nachoxidationsschritt überflüssig. Alle anderen Schichtbereiche sind ohnehin transparent. Das Verfahren zielt in diesem Fall also nicht auf die Erreichung einer möglichst schwachen, aber sehr gleichmäßigen Unterstöchiometrie, sondern auf die Erzeugung einer Gradientenschicht, die in ihrem unteren Bereich eine sehr dünne, aber durchaus stärker unterstöchiometrische Zone aufweist. Die Gleichmäßigkeitsanforderung in Bezug auf die optische Transmission ist dadurch wesentlich einfacher zu erfüllen. Der erfindungsgemäße Einsatz des Hohlkathodenbogenentladungsplasmas sorgt zusätzlich für eine Verringerung der Abhängigkeit der Barriereeigenschaften von der Stöchiometrie der Oxidschicht und erweitert damit den zur Verfügung stehenden Arbeitsbereich. Eine besonders hohe Prozesssicherheit ergibt sich, wenn Prozessparameter geregelt werden. Besonders vorteilhaft ist es, wenn die jeweiligen Prozessparameter für einzelne Sektoren des Bedampfungsbereiches separat geregelt werden. Dafür eignen sich als zu regelnde Prozessparameter die pro Zeiteinheit verdampfte Aluminiummenge und/oder der Reaktivgasfluss. Besonders vorteilhaft ist es, wenn die Regelung eine transmissionsgesteuerte Regelung der Sauerstoffzufuhr ist, bei der die Sauerstoffzufuhr so eingestellt wird, dass die optische Transmission, welche während des Prozesses kontinuierlich oder periodisch gemessen wird, auf einem Sollwert gehalten wird.

Eine besonders vorteilhafte Ausgestaltung des Verfahrens besteht darin, zur Begrenzung des Bedampfungsbereiches eine bewegliche Blende anzuordnen. Damit lassen sich für den Fall, dass sich aus konstruktiven Gründen - z. B. im unteren Teil der Schicht - überstöchiometrische Bereiche nicht vermeiden lassen, diese ausblenden.

Anhand eines Ausführungsbeispieles wird die Erfindung näher beschrieben.

In einer an sich bekannten Bandbedampfungsanlage, bestehend aus einem Rezipienten mit angeschlossenem Vakuumpumpsystem und Bandwickeleinrichtung, wird das zu bedampfende Substrat - in diesem Fall eine PET-Folie - an einer mit Titantargets belegten Magnetronquelle vorbeigeführt, die unter Einlass von Argon und Sauerstoff als Sputterquelle dient. Als Magnetronquelle werden Einzel- oder Doppelanordnungen von Magnetrons verwendet. Die eingespeiste Leistung wird so eingestellt, dass sich auf dem Substrat eine nicht geschlossene Schicht bildet. Die Flächenbelegung liegt dabei unter einer effektiven Schichtdicke von einem Nanometer. Die optimale Sputterleistung hängt von der realisierten Bandgeschwindigkeit ab. So haben sich bei Bandgeschwindigkeiten um 5 m/s Leistungsdichten bis 15 W/cm² Targetfläche bewährt. Anschließend wird das Substrat über eine Kühlwalze geführt. Darunter befindet sich in Verdampferschiffchen das Verdampfungsgut, welches den Verdampferschiffchen in bekannter Weise kontinuierlich zugeführt wird und auf das Substrat aufgedampft wird. Das Verdampferschiffchen wird mit konstanter Verdampfungsrate betrieben. Der wirksame Bedampfungsbereich ist mittels einer beweglichen Blende einstellbar. Seitlich vom Bedampfungsbereich zwischen der Kühlwalze und dem Verdampferschiffchen sind Gaseinlassdüsen für die Zuführung des Reaktivgases Sauerstoff angeordnet. Die Positionen der Gaseinlassdüsen sowie deren Winkel sind in Pfeilrichtung einstellbar. Der Reaktivgasfluss durch die Gaseinlassdüsen in der Nähe der Bandeinlaufzone ist manuell einstellbar. Der Reaktivgasfluss durch die anderen Gaseinlassdüsen erfolgt transmissionsgeregelt. Die dafür erforderliche Messung der optischen Transmission erfolgt mittels bekannter Messeinrichtungen außerhalb der Bedampfungszone, jedoch vor Erreichen des Aufwickels.

Das erfindungsgemäße Verfahren wird im Falle der Ausbildung einer Schicht mit einem Stöchiometriegradienten wie folgt ausgeführt:

Die Inbetriebnahme der Aluminiumverdampfung erfolgt in bekannter Weise. Danach wird der Reaktivgasfluss an den Gaseinlassdüsen in der Nähe der Bandeinlaufzone auf 0 bis 40 % der entsprechend der chemischen Reaktionsgleichung für eine vollständige Oxidation der gesamten Schicht erforderlichen Menge Sauerstoff eingestellt. Im Anschluss daran werden die geregelten Gaseinlassdüsen auf der Bandauslaufseite unter Vorgabe des gewünschten Sollwertes der optischen Transmission von 80 bis 95 % geöffnet, worauf sich der noch benötigte Reaktivgasfluss automatisch einstellt.

Bei Beginn des Verfahrens oder nach Veränderungen der Positionen der Gaseinlassdüsen oder Blenden ist der einzustellende Reaktivgasfluss an den Gaseinlassdüsen wie folgt zu ermitteln:
Das Substrat wird bei verschiedenen Einstellungen des Reaktivgasflusses an den Gaseinlassdüsen bedampft. Danach erfolgt die Vermessung der bedampften Substrate bezüglich ihrer Permeationswerte für Wasserdampf und/oder Sauerstoff. Anschließend wird an den Gaseinlassdüsen der Reaktivgasfluss, bei welchem sich der niedrigste Permeationswert für Wasserdampf und/oder Sauerstoff ergab, eingestellt.

## Patentansprüche

1. Verfahren zum Bedampfen bandförmiger Substrate mit einer transparenten Barriereschicht aus Aluminiumoxid durch reaktive Verdampfung von Aluminium und Einlass von Reaktivgas in einer Bandbedampfungsanlage, wobei zwischen Substrat und Aluminiumoxidschicht eine Magnetronsputterschicht aus Metall oder Metalloxid abgeschieden wird, **dadurch gekennzeichnet, dass** die Magnetronsputterschicht als unvollständig geschlossene Schicht mit einer Schichtdicke von weniger als einem Nanometer ausgebildet wird, wobei die Flächenbelegung nur so hoch eingestellt wird, dass nicht einmal eine vollständige Atomlage oder Moleküllage mit Sputtermaterial ausgebildet werden kann.

2. Verfahren nach Anspruch 1, **dadurch gekennzeichnet, dass** zur Bildung der unvollständig geschlossenen Schicht Titan oder Magnesium gesputtert wird.

3. Verfahren nach Anspruch 2, **dadurch gekennzeichnet, dass** das Sputtern reaktiv unter Sauerstoffeinlass erfolgt.

4. Verfahren nach einem der Ansprüche 1 bis 3, **dadurch gekennzeichnet,**
**dass** der Einlass des Reaktivgases derart erfolgt, dass sich in der Bedampfungszone in Bandlaufrichtung ein Partialdruckgradient des Reaktivgases einstellt,
**dass** sich das Mischungsverhältnis zwischen Aluminium, Aluminiumoxid und Sauerstoff in der Barriereschicht als Gradient ausbildet,
**dass** dieses Mischungsverhältnis in der Barriereschicht ein Maximum des Anteils des metallischen Aluminiums aufweist und die Lage und Ausprägung dieses Maximums in einem bestimmten Tiefenbereich der Barriereschicht durch Variation des Partialdruckgradienten des Reaktivgases und der Lage der Bedampfungszone derart eingestellt wird, dass bei gleicher optischer Transmission der Barriereschicht die Sauerstoffpermeation und/oder die Wasserdampfpermeation ein Minimum erreicht.

5. Verfahren nach Anspruch 4, **dadurch gekennzeichnet, dass** die Lage und Ausprägung des Maximums an metallischem Aluminium in einem bestimmten Tiefenbereich der Barriereschicht durch Verstellen von Blenden im Verdampfungsbereich und/oder Veränderung der Position des Verdampferschiffchens und/oder Veränderung der Position der Gaseinlassdüse und/oder des Winkels der Gaseinlassdüsen für das Reaktivgas und/oder die Veränderung der Reaktivgasflüsse eingestellt wird.

6. Verfahren nach einem der Ansprüche 4 oder 5, **dadurch gekennzeichnet, dass** das Aluminium aus einem Schiffchenverdampfer mit mindestens einem Verdampferschiffchen mit kontinuierlicher Drahtzufuhr verdampft wird.

7. Verfahren nach einem der Ansprüche 4 oder 5, **dadurch gekennzeichnet, dass** das Aluminium aus einem Induktionsverdampfer verdampft wird.

8. Verfahren nach einem der Ansprüche 4 oder 5, **dadurch gekennzeichnet, dass** das Aluminium aus einem Elektronenstrahlverdampfer verdampft wird.

9. Verfahren nach Anspruch 5, **dadurch gekennzeichnet, dass** der Partialdruckgradient des Reaktivgases durch Variation des Verhältnisses der Reaktivgasflüsse der im Bereich der Bandeinlaufzone und Bandauslaufzone angeordneten, separat einstellbaren Gaseinlassdüsen eingestellt wird.

10. Verfahren nach mindestens einem der Ansprüche 1 bis 9, **dadurch gekennzeichnet, dass** Prozessparameter geregelt werden.

11. Verfahren nach Anspruch 10, **dadurch gekennzeichnet, dass** die Prozessparameter für einzelne Sektoren des Bedampfungsbereiches separat geregelt werden.

12. Verfahren nach Anspruch 10 oder 11, **dadurch gekennzeichnet, dass** die zu regelnden Prozessparameter die pro Zeiteinheit verdampfte Aluminiummenge und/oder der Reaktivgasfluss sind.

13. Verfahren nach Anspruch 10 oder 11, **dadurch gekennzeichnet, dass** die Regelung eine transmissionsgesteuerte Regelung der Sauerstoffzufuhr ist, bei der die Sauerstoffzufuhr so eingestellt wird, dass die optische Transmission, welche während des Prozesses kontinuierlich oder periodisch gemessen wird, auf einem Sollwert gehalten wird.

14. Verfahren nach mindestens einem der Ansprüche 1 bis 13, **dadurch gekennzeichnet, dass** plasmaaktiviert bedampft wird.

15. Verfahren nach Anspruch 14, **dadurch gekennzeichnet, dass** zur Plasmaaktivierung ein Hohlkathodenbogenentladungsplasma eingesetzt wird.

16. Verfahren nach Anspruch 15, **dadurch gekennzeichnet, dass** die Plasmaquellen so betrieben werden, dass sich am Substrat eine durchschnittliche Ionenstromdichte von mindestens 20 mA/cm² extrahieren lässt.

17. Verfahren nach Anspruch 15, **dadurch gekennzeichnet, dass** die Plasmaquellen so betrieben werden, dass sich am Substrat eine durchschnittliche Ionenstromdichte von mindestens 50 mA/cm² extrahieren lässt.

## Claims

1. A method for the vapour deposition of strip-shaped substrates with a transparent barrier layer of aluminium oxide by reactive vaporisation of aluminium and admission of a reactive gas in a strip vapour deposition system, wherein
a magnetron sputter layer of metal or metal oxide is deposited between substrate and aluminium oxide layer,
**characterised in that** the magnetron sputter layer is formed as an incompletely closed layer with a layer thickness of less than one nanometre, wherein
the surface coating is adjusted to be only so thick that not even one complete atomic layer or molecular layer can be formed with sputter material.

2. The method according to Claim 1,
**characterised in that** titanium or magnesium is sputtered for the formation of the incompletely closed layer.

3. The method according to Claim 2,
**characterised in that** the sputtering takes place reactively with the admission of oxygen.

4. The method according to one of the Claims 1 to 3,
**characterised in that** the admission of the reactive gas takes place such that in the vapour deposition zone in the strip direction of travel a partial pressure gradient of the reactive gas arises, and
**in that** the mixing ratio between aluminium, aluminium oxide and oxygen in the barrier layer forms as a gradient, and
**in that** this mixing ratio in the barrier layer has a maximum of the component of the metallic aluminium, and the position and shaping of this maximum in a particular depth region of the barrier layer is adjusted by variation of the partial pressure gradient of the reactive gas and the position of the vapour deposition zone such that with the same optical transmission of the barrier layer the oxygen permeation and/or the water vapour permeation achieves a minimum.

5. The method according to Claim 4,
**characterised in that** the position and shaping of a maximum in metallic aluminium in a particular depth region of the barrier layer is adjusted by the movement of apertures in the vaporisation region and/or alteration of the position of the vaporiser crucible and/or alteration of the position of the gas admission nozzle and/or of the angle of the gas admission nozzles for the reactive gas and/or the alteration of the reactive gas flows.

6. The method according to one of the Claims 4 or 5,
**characterised in that** the aluminium is vaporised from a crucible vaporiser with at least one vaporiser crucible with a continuous wire supply.

7. The method according to one of the Claims 4 or 5,
**characterised in that** the aluminium is vaporised from an induction vaporiser.

8. The method according to one of the Claims 4 or 5,
**characterised in that** the aluminium is vaporised from an electron beam vaporiser.

9. The method according to Claim 5,
**characterised in that** the partial pressure gradient of the reactive gas is adjusted by variation of the ratio of the reactive gas flows of the separately adjustable gas admission nozzles arranged in the region of the strip inlet zone and strip outlet zone.

10. The method according to one of Claims 1 to 9,
**characterised in that** process parameters are regulated.

11. The method according to Claim 10,
**characterised in that** the process parameters for individual sectors of the vapour deposition region are separately regulated.

12. The method according to Claim 10 or 11,
**characterised in that** the process parameters to be regulated are the quantity of aluminium vaporised per unit of time and/or the reactive gas flow.

13. The method according to Claim 10 or 11,
**characterised in that** the regulation is a transmission-controlled regulation of the oxygen supply, by which the oxygen supply is adjusted such that the optical transmission, which during the process is continuously or periodically measured, is maintained at a required value.

14. The method according to at least one of the Claims 1 to 13,
**characterised in that** the vapour deposition is plasma-activated.

15. The method according to Claim 14,
**characterised in that** a hollow cathode arc discharge plasma is used for the plasma activation.

16. The method according to Claim 15,
**characterised in that** the plasma sources are operated such that an average ion current density of at least 20 mA/cm² can be extracted on the substrate.

17. The method according to Claim 15,
**characterised in that** the plasma sources are operated such that an average ion current density of at least 50 mA/cm² can be extracted on the substrate.

## Revendications

1. Procédé de métallisation de substrats en forme de bande par dépôt-vapeur d'une couche barrière transparente en oxyde d'aluminium, par évaporation réactive d'aluminium et apport de gaz réactif dans une installation de métallisation sous vide de bandes, et selon lequel une couche de crépitement de magnétrons en métal ou en oxyde de métal est déposée entre le substrat et la couche d'oxyde d'aluminium,
**caractérisé en ce que**
la couche de crépitement de magnétrons est une couche non complètement fermée dont l'épaisseur de couche est inférieure à un nanomètre, et on règle le revêtement superficiel de sorte à ne même pas pouvoir former une couche d'atomes ou de molécules complète avec du matériau de crépitement.

2. Procédé selon la revendication 1,
**caractérisé en ce que**
pour former la couche non complètement fermée on crépite du titane ou du magnésium.

3. Procédé selon la revendication 2,
**caractérisé en ce que**
le crépitement s'effectue de façon réactive par apport d'oxygène.

4. Procédé selon l'une quelconque des revendications 1 à 3,
**caractérisé en ce que**
l'apport du gaz réactif s'effectue de façon à établir un gradient de pression partielle du gaz réactif dans la région de métallisation sous vide dans la direction de marche de la bande, le rapport de mélange entre l'aluminium, l'oxyde d'aluminium et l'oxygène se forme comme gradient dans la couche barrière, ce rapport de mélange dans la couche de barrière présente un maximum de la proportion de l'aluminium métallique, et on règle la position et l'importance de ce maximum dans une zone de profondeur déterminée de la couche de barrière en modifiant le gradient de pression partielle du gaz réactif et la position de la zone de métallisation sous vide, de sorte que pour une même transmission optique de la couche de barrière, la perméation d'oxygène et/ ou la perméation de vapeur d'eau atteigne un minimum.

5. Procédé selon la revendication 4,
**caractérisé en ce que**
la position et l'importance du maximum d'aluminium métallique dans une zone de profondeur déterminée de la couche de barrière sont réglées par ajustement d'écrans dans la zone d'évaporation et/ou modification de la position de la navette d'évaporateur et/ou modification de la position de buse d'entrée de gaz et/ou de l'angle des buses d'entrée de gaz pour le gaz réactif et/ou modification des flux de gaz réactif.

6. Procédé selon l'une quelconque des revendications 4 ou 5,
**caractérisé en ce que**
l'aluminium de l'évaporateur à navette est évaporé à l'aide d'au moins une navette d'évaporateur avec apport continu de fil.

7. Procédé selon l'une quelconque des revendications 4 ou 5,
**caractérisé en ce que**
l'aluminium est évaporé à partir d'un évaporateur à induction.

8. Procédé selon l'une quelconque des revendications 4 ou 5,
**caractérisé en ce que**
l'aluminium est évaporé à partir d'un évaporateur à faisceau électronique.

9. Procédé selon la revendication 5,
**caractérisé en ce que** le gradient de pression partielle du gaz réactif est réglé par variation du rapport des flux de gaz réactif des buses d'entrée de gaz, réglables séparément dans la région de la zone d'entrée de bande et de la zone de sortie de bande.

10. Procédé selon au moins l'une quelconque des revendications 1 à 9,
**caractérisé en ce que**
l'on régule des paramètres de processus.

11. Procédé selon la revendication 10,
**caractérisé en ce que**
l'on régule séparément les paramètres de processus pour différents secteurs de la région de métallisation sous vide.

12. Procédé selon la revendication 10 ou 11,
**caractérisé en ce que**
les paramètres de processus à réguler sont la quantité d'aluminium évaporée par unité de temps et/ ou le flux de gaz réactif.

13. Procédé selon la revendication 10 ou 11,
**caractérisé en ce que**
la régulation est une régulation à transmission commandée de l'apport d'oxygène au niveau de laquelle l'apport d'oxygène est réglé pour maintenir à une valeur de consigne la transmission optique qui est mesurée continuellement ou périodiquement pendant le processus.

14. Procédé selon au moins l'une quelconque des revendications 1 à 13,
**caractérisé en ce que**
la métallisation sous vide s'effectue par activation au plasma.

15. Procédé selon la revendication 14,
**caractérisé en ce que**
pour l'activation au plasma, on utilise un plasma à décharge d'arc à cathode creuse.

16. Procédé selon la revendication 15,
**caractérisé en ce que**
les sources de plasma sont exploitées pour pouvoir extraire sur le substrat une densité de courant ionique moyenne d'au moins 20 mA/cm².

17. Procédé selon la revendication 15,
**caractérisé en ce que**
les sources de plasma sont exploitées pour pouvoir extraire sur le substrat une densité de courant ionique moyenne d'au moins 50 mA/cm².
